# EUROPÄISCHE PATENTANMELDUNG

(11) **EP 4 746 224 A1**
(43) Veröffentlichungstag der Anmeldung: **20.05.2026**
(21) Anmeldenummer: 24213472.4
(22) Anmeldetag: 18.11.2024
(51) Int. Cl.: H02H 9/00, H02H 3/44, H02H 7/122, H02H 7/18

(54) **ANTRIEBSEINHEIT FÜR EINE MOBILE WERKZEUGMASCHINE UND MOBILE WERKZEUGMASCHINE**

(71) Anmelder: Hilti Aktiengesellschaft, 9494 Schaan (LI)
(72) Erfinder: Hurka, Florian, 86459 Margertshausen (DE); Öchsner, Valentin, 86179 Augsburg (DE); Bauer, Dominik, 86836 Untermeitingen (DE)
(74) Vertreter: Hilti Aktiengesellschaft Corporate Intellectual Property

(57) **Zusammenfassung**

Die vorliegende Erfindung betrifft eine Antriebseinheit für eine mobile Werkzeugmaschine (100), aufweisend eine Akkueinheit (112) zum Bereitstellen einer ausgangsseitigen Gleichspannung, einen Elektromotor (102), eine Motorinverter-Schaltung (202), die zwischen der Akkueinheit und dem Elektromotor geschaltet ist, und durch die die von der Akkueinheit bereitgestellte Gleichspannung taktbar ist, um den Elektromotor anzutreiben, eine Zwischenkreiskapazität (205), die zwischen der Akkueinheit und der Motorinverter-Schaltung geschaltet und durch die eine Zwischenkreisspannung definiert ist; und eine Schutzschalteinrichtung (206) mit einem Schutzschalter (207), wobei die Schutzschalteinrichtung dazu ausgebildet ist, einen Spannungsgradienten der Zwischenkreisspannung zu erfassen, und unter Verwendung des Spannungsgradienten den Schutzschalter zum Trennen der Akkueinheit von der Motorinverter-Schaltung zu schalten.

Fig. 3

## Beschreibung

### GEBIET DER ERFINDUNG

Die vorliegende Erfindung betrifft eine Antriebseinheit für eine mobile Werkzeugmaschine und eine mobile Werkzeugmaschine mit einer solchen Antriebseinheit.

Bekannte mobile Werkzeugmaschinen umfassen eine Antriebseinheit, die eine Akkueinheit, einen Zwischenkreis, eine Motorinverter-Schaltung und einen Elektromotor aufweist. In solchen Antriebseinheiten kommen oftmals Schutzschalter zum Einsatz. Durch einen derartigen Schutzschalter kann die Akkueinheit, beispielsweise beim Einschalten oder in einem Kurzschlussfall, von einem Zwischenkreis der Antriebseinheit entkoppelt werden, um so die Ackueinheit und/oder die weiteren Komponenten der Antriebseinheit vor hohen einfließenden Strömen zu schützen. Derartige hohe Ströme bzw. Stromspitzen können beispielsweise beim Einschalten oder Einstecken der Akkueinheit entstehen und zu Funkenüberschlägen führen, was die Kontakte der Akkueinheit stark verschleißen lässt.

Der Schutzschalter kann dabei üblicherweise in einer Zuleitung zu einer positiven Elektrode der Akkueinheit bzw. zwischen der Akkueinheit und dem Zwischenkreis der Antriebseinheit angeordnet sein. Alternativ sind auch Topologien bekannt, bei denen der Schutzschalter in einer Ableitung zu einer negativen Elektrode der Akkueinheit bzw. zwischen der Akkueinheit und dem Zwischenkreis der Antriebseinheit angeordnet ist.

Da der Schutzschalter oft sicherheitskritische Funktionen übernimmt, ist es wichtig, dass der Schutzschalter im Falle eines Kurzschlusses nicht ausfällt oder durch einen solchen Kurzschluss beschädigt wird. Ferner muss der Schutzschalter im Falle eines Defekts geöffnet werden, um so die Akkueinheit von dem Zwischenkreis zu entkoppeln. Zum Öffnen des Schutzschalters wird dieser durch ein Schaltsignal angesteuert, was zuvor auf Basis von Messungen innerhalb der Antriebseinheit erzeugt wurde. Die aus dem Stand der Technik bekannten Verfahren messen dabei einen Strom über einen Messwiderstand und vergleichen diesen Messstrom mit einem vorbestimmten Referenz-Stromwert, der dem maximal zulässigen Strom innerhalb der Antriebseinheit entspricht. Überschreitet der Messstrom den vorbestimmten Referenz-Stromwert, wird das Schaltsignal erzeugt, und der Schutzschalter geöffnet, sodass kein Strom mehr von der Akkueinheit in den Zwischenkreis und somit in die Motorinverter-Schaltung und umgekehrt fließen kann.

Die Messung über den Messwiderstand ist dabei nicht leistungsfrei. So können durch die Messung über den Messwiderstand mehrere Watt Verluste entstehen, die einen Hotspot und zudem thermische Probleme innerhalb der Antriebseinheit erzeugen können. Bei typischen Batterieströmen von ca. 100 A kann an einem Messwiderstand mit 1 mΩ insbesondere eine Verlustleistung von 10 Watt entstehen. Um diese zu kühlen, erfordert es eine Kühlung mit Kühlkörper und einem Kühlluftstrom. Es besteht also weiterhin Verbesserungsbedarf.

Eine Aufgabe der vorliegenden Erfindung ist es daher, eine verbesserte Antriebseinheit für eine mobile Werkzeugmaschine und/oder eine verbesserte mobile Werkzeugmaschine bereitzustellen, und insbesondere eine verbesserte Schutzschaltung für die Antriebseinheit anzugeben.

### OFFENBARUNG DER ERFINDUNG

Demgemäß wird eine Antriebseinheit für eine mobile Werkzeugmaschine vorgeschlagen. Die Antriebseinheit umfasst eine Akkueinheit zum Bereitstellen einer ausgangsseitigen Gleichspannung, einen Elektromotor, eine Motorinverter-Schaltung, die zwischen der Akkueinheit und dem Elektromotor geschaltet ist, und durch die die von der Akkueinheit bereitgestellte Gleichspannung taktbar ist, um den Elektromotor anzutreiben, eine Zwischenkreiskapazität, die zwischen der Akkueinheit und der Motorinverter-Schaltung geschaltet und durch die eine Zwischenkreisspannung definiert ist, und eine Schutzschalteinrichtung mit einem Schutzschalter. Die Schutzschalteinrichtung ist dazu ausgebildet, einen Spannungsgradienten der Zwischenkreisspannung zu erfassen, und unter Verwendung des Spannungsgradienten den Schutzschalter zum Trennen der Akkueinheit von der Motorinverter-Schaltung, insbesondere bei Auftreten eines Kurzschlusses im Zwischenkreis der Antriebseinheit, zu schalten.

Alternativ wird eine Antriebseinheit für eine mobile Werkzeugmaschine vorgeschlagen. Die Antriebseinheit umfasst eine Akkueinheit zum Bereitstellen einer ausgangsseitigen Gleichspannung, einen Elektromotor, eine Motorinverter-Schaltung, die zwischen der Akkueinheit und dem Elektromotor geschaltet ist, und durch die die von der Akkueinheit bereitgestellte Gleichspannung taktbar ist, um den Elektromotor anzutreiben, eine Zwischenkreiskapazität, die zwischen der Akkueinheit und der Motorinverter-Schaltung geschaltet und durch die eine Zwischenkreisspannung definiert ist, und eine Messeinrichtung, die dazu ausgebildet ist, einen Spannungsgradienten der Zwischenkreisspannung zu erfassen, und unter Verwendung des Spannungsgradienten die Motorinverter-Schaltung abzuschalten. Alternativ zu der Schutzschalteinrichtung, kann auch direkt die Motorinverter-Schaltung auf Basis des Spannungsgradienten ausgeschaltet werden, um derart einen Kurzschluss zu vermeiden. Hierzu kann die Messeinrichtung zum Messen des Spannungsgradienten vorgesehen sein. Alle Ausführungen, die sich auf das Messen des Spannungsgradienten beziehen, und nachfolgend für die Schutzschalteinrichtung ausgeführt sind, gelten auch analog für die Messeinrichtung.

Die Akkueinheit ist vorzugsweise dazu ausgebildet, eine Gleichspannung (DC) zu liefern. Die Akkueinheit wird vorzugsweise zur Energieversorgung des Elektromotors verwendet. Die Akkueinheit weist vorzugsweise mindestens zwei oder mehr Kontakte bzw. Kontaktpunkte auf. Diese Kontakte sind vorzugsweise Verbindungspunkte, über die die elektrische Energie von der Akkueinheit an die Antriebseinheit übertragen wird. Die Akkueinheit ist vorzugsweise ein wiederaufladbarer Energiespeicher bzw. eine wiederaufladbare Batterie, der/die elektrische Energie speichern und bei Bedarf wieder abgeben kann.

Die Motorinverter-Schaltung bildet vorzugsweise eine Motorinverterbrücke, die als Spannungsquellenwechselrichter (Voltage-Source-Inverter, VSI) fungieren kann. Dabei wird die Gleichspannung, die von der Akkueinheit bereitgestellt wird, vorzugsweise mithilfe einer Pulsweitenmodulation in Wechselspannung umgewandelt. Diese getaktete Wechselspannung ermöglicht es, den Elektromotor anzutreiben. Die Pulsweitenmodulation sorgt für die präzise Steuerung der Ausgangsspannung und -frequenz, wodurch die Leistungsabgabe des Elektromotors effizient reguliert werden kann.

Durch die Zwischenkreiskapazität wird ein Zwischenkreis der Antriebseinheit definiert. Die Zwischenkreiskapazität kann vorzugsweise einen Zwischenkreiskondensator aufweisen. Der Zwischenkreiskondensator kann ein keramischer Kondensator sein. Ein keramischer Kondensator ist eine Art elektrischer Kondensator, der Keramik als dielektrisches Material verwendet. Diese Kondensatoren umfassen vorzugsweise dünne Keramikschichten, die mit Metallfolien als Elektroden abwechselnd geschichtet sind. Keramische Kondensatoren sind aufgrund ihrer hohen Stabilität, Temperaturbeständigkeit und Kapazität in einem kompakten Format eingesetzt. MLCC steht für Multilayer Ceramic Capacitor (auf Deutsch: Vielschicht-Keramikkondensator). MLCCs sind eine spezielle Art keramischer Kondensatoren, die aus mehreren Schichten aus keramischem Material und Metall bestehen, die abwechselnd übereinander gestapelt und dann in einem kleinen, kompakten Gehäuse zusammengepresst werden. Diese Bauweise ermöglicht hohe Kapazitätswerte in einem kleinen Bauraum.

Ein Spannungsabfall über den Zwischenkreiskondensator definiert vorzugsweise die Zwischenkreisspannung. Die Zwischenkreiskapazität wird in einem Antriebsstrang mit Akkueinheit und Schalteinrichtung in Parallelschaltung eingesetzt, um Spannungsschwankungen zu glätten und stabile Betriebsbedingungen sicherzustellen. Die Akkueinheit kann beispielsweise plötzliche Laständerungen nicht immer direkt und schnell ausgleichen, daher puffert die Zwischenkreiskapazität Energie und versorgt die Motorinverter-Schaltung (zum Beispiel den Wechselrichter) bei Bedarf mit zusätzlicher Energie. Dies reduziert Spannungsspitzen und schützt die Komponenten vor Schäden durch hohe Ströme. Gleichzeitig unterstützt die Zwischenkreiskapazität die Pulsweitenmodulation, indem sie schnelle Stromschwankungen abfedert, was die Effizienz und Lebensdauer des gesamten Systems erhöht.

Die Schutzschalteinrichtung ist dazu ausgebildet, im Notfall bzw. im Kurzschlussfall eine Verbindung zwischen der Akkueinheit und dem Zwischenkreis bzw. der Motorinverter-Schaltung zu trennen, um derart die Akkueinheit vor einer plötzlichen Überlastung durch Stromspitzen im Kurzschlussfall zu schützen. Hierzu weist die Schutzschalteinrichtung den Schutzschalter auf, der im Kurzschlussfall, beispielsweise auf Basis eines Schaltsignals, geöffnet werden kann.

Die vorliegende Antriebseinheit ermöglicht durch die Art der Schaltung des Schutzschalters, nämlich auf Basis des Spannungsgradienten, anstelle auf Basis eines Messstroms, eine verlustarme und schnelle Messung. Damit wiederum wird eine schnelle Schaltung, beispielsweise in wenigen Mikrosekunden, des Schutzschalters ermöglicht, sodass die Antriebseinheit im Kurzschlussfall oder allgemein in einem Fehlerfall und/oder beim Einschalten geschützt werden kann. Der Spannungsgradient kann auch als Spannungsabfall bezeichnet werden. Der hiesige Ansatzbietet eine Möglichkeit, einen Kurzschluss auf Basis des Spannungsgradienten zu erkennen und den Schutzschalter beim Erkennen zu öffnen bzw. derart die Antriebseinheit abzuschalten. Durch die Art der Erfassung des Kurzschlussfalls, auf dessen Basis der Schutzschalter geöffnet werden kann, wird keine Verlustleistung bzw. Wärme erzeugt. Somit kann auch auf eine Kühlung, die ansonsten für einen Messwiderstand zur Messung eines (Kurzschluss-)Stroms notwendig war, verzichtet werden.

Gemäß einem weiteren Aspekt wird eine mobile Werkzeugmaschine mit einer derartigen Antriebseinheit vorgeschlagen.

Die mobile Werkzeugmaschine kann ein handgeführtes Elektrowerkzeug bzw. eine Handwerkzeugmaschine, beispielsweise eine Bohrmaschine, eine Schraubmaschine, eine Meißelmaschine, eine Schleifmaschine, eine Sägemaschine oder dergleichen sein. Denkbar ist auch, dass die mobile Werkzeugmaschine ein Bauroboter ist oder einen Bauroboter umfasst. Die mobile Werkzeugmaschine kann einen Manipulator, insbesondere einen mehrachsigen Manipulator, aufweisen. Die mobile Werkzeugmaschine kann eine Antriebsvorrichtung zum Antrieb eines Werkzeugs, beispielsweise eines Bohrers, eines Meißels, eines Saugers oder dergleichen aufweisen.

Die mobile Werkzeugmaschine kann beispielsweise zur Bearbeitung von Stein, wie Beton, und/oder Metall und/oder Holz eingerichtet sein. Sie kann beispielsweise zum Bohren, Meißeln, Sägen und / oder Schleifen ausgebildet sein.

Allgemein kann die mobile Werkzeugmaschine zur Ausführung von Arbeiten im Hoch- und/oder Tiefbau eingerichtet sein. Denkbar ist, dass sie nicht für einen Einsatz im Bergbau eingerichtet ist.

Die mobile Werkzeugmaschine kann tragbar sein; sie kann beispielsweise ein Gewicht von weniger als 50 kg, insbesondere von weniger als 25 kg, aufweisen.

In einer Ausführungsform wird vorgeschlagen, dass der Schutzschalter einen Transistor, insbesondere einen MOSFET, aufweist.

Der Schutzschalter kann als Gate-Terminal-Transistor, insbesondere als Metalloxid-Halbleiter-Feldeffekttransistor, und/oder als 3-Terminal-Transistor, insbesondere als High-Electron-Mobility Transistor, ausgebildet sein. Grundsätzlich sind auch andere, halbleiterbasierte Transistortypen, wie Gate-isolierte Bipolar-Transistoren (IGBTs), einsetzbar.

In einer Ausführungsform wird vorgeschlagen, dass die Schutzschalteinrichtung einen Spannungsteiler zum Teilen der Zwischenkreisspannung und eine Differenziator-Schaltung zum Erfassen des Spannungsgradienten unter Verwendung der geteilten Zwischenkreisspannung aufweist.

Um diesen (steilen) Spannungsgradienten bzw. Spannungsabfall zu erkennen, wird vorzugsweise als Differenziator-Schaltung eine OPAMP-Schaltung verwendet, die die Zwischenkreisspannung, insbesondere nach erfolgter Spannungsteilung, differenzieren kann. Die Spannungsteilung kann beispielsweise mit einem Teilungsfaktor 10 erfolgen, sodass eine Zwischenkreisspannung von 22 Volt für die Differenziator-Schaltung auf 2,2 Volt geteilt wird. Auch andere Teilungsfaktoren sind selbstredend denkbar. Durch den Spannungsteiler wird der Spannungsgradient vorzugsweise nicht verändert.

Eine Differenziator-Schaltung ist eine elektronische Schaltung, die die zeitliche Änderung eines Eingangssignals ermittelt, also seine Ableitung bildet. In einer OPAMP-Schaltung (Operationsverstärkerschaltung) wird ein Operationsverstärker so konfiguriert, dass er als Differenziator arbeitet. Dabei wird ein Kondensator am Eingang und ein Widerstand in der Rückkopplung des OPAMPs verwendet. Diese Anordnung sorgt dafür, dass die Ausgangsspannung proportional zur Änderungsrate der Eingangsspannung ist.

In einer Ausführungsform wird vorgeschlagen, dass die Differenziator-Schaltung dazu ausgebildet ist, ein Ausgangsspannungssignal zu erzeugen, das dem Spannungsgradienten der Zwischenkreisspannung entspricht.

Am Ausgang der Differenziator-Schaltung liegt vorzugsweise eine Spannung, das Ausgangsspannungssignal, an, die/das dem Spannungsgradienten bzw. der Ableitung der Eingangsspannung des Zwischenkreises (nach erfolgter Spannungsteilung) entspricht. Dieses Ausgangsspannungssignal, das dem Zwischenkreisspannungsgradienten entspricht, wird vorzugsweise mittels eines Komparators mit einem Schwellenwert bzw. einem Pegel verglichen, welcher dem noch zulässigen Spannungsgradienten entspricht oder direkt als Schaltsignal für das Schalten des Schutzschalters der Schutzschalteinrichtung zugeführt.

In einer Ausführungsform wird vorgeschlagen, dass die Schutzschalteinrichtung einen Komparator aufweist, durch den ein Schwellenwert zum Schalten des Schutzschalters einstellbar ist, und der dazu ausgebildet ist, das Ausgangsspannungssignal mit dem Schwellenwert zu vergleichen, und auf Basis des Vergleichs ein Komparator-Signal auszugeben.

Ein Komparator ist eine elektronische Schaltung oder ein Bauteil, das zwei Spannungen miteinander vergleicht und je nach Ergebnis eine bestimmte Ausgangsspannung ausgibt. In der Regel liefert ein Komparator ein digitales Ausgangssignal. Wenn die Eingangsspannung an einem Eingang größer ist als die am anderen, wird ein hoher Pegel ausgegeben (z. B. 1 oder High), andernfalls ein niedriger Pegel (z. B. 0 oder Low). Wenn der Spannungsgradient hoch genug ist, wird also beispielsweise ein Komparator-Signal mit ausreichend hohem Pegel erzeugt, um die Schutzschalteinrichtung direkt zu triggern. Alternativ kann das Komparator-Signal auch als binäres Signal erzeugt werden, auf dessen Basis dann ein Schaltsignal erzeugbar ist. Das Komparator-Signal kann beispielsweise als kurzer Signal-Puls erzeugt werden, der durch den (plötzlichen) Spannungsabfall im Kurzschlussfall erzeugt wird.

In einer Ausführungsform wird vorgeschlagen, dass die Schutzschalteinrichtung einen Flipflopspeicher oder einen Mikrokontroller aufweist, wobei der Flipflopspeicher oder der Mikrokontroller dazu ausgebildet ist, unter Verwendung des Komparator-Signals den Schutzschalter, insbesondere durch Erzeugen eines Schaltsignals, zu schalten, um die Akkueinheit von der Motorinverter-Schaltung, insbesondere in einem Kurzschlussfall, zu trennen.

Das Komparator-Signal, das beispielsweise als Schaltsignal zum Schalten des Schutzschalters dient, wird beispielsweise in einen Flipflopspeicher eingeleitet, um das Komparator-Signal im Kurzschlussfall bzw. im Fehlerfall zu speichern und die Schutzschalteinrichtung vor einem unbeabsichtigten Wiedereinschalten zu schützen.

Ein Flipflopspeicher ist vorzugsweise eine digitale Schaltung, die zwei stabile Zustände aufweist und daher ein einzelnes Bit (0 oder 1) speichern kann. Der Flipflopspeicher speichert dabei die Informationen des (letzten) Komparator-Signals, bis sie durch ein Eingabesignal (z. B. einen Taktimpuls des Komparator-Signals) verändert werden.

Ein Mikrocontroller ist vorzugsweise ein integrierter Schaltkreis (IC), der als kleiner, eigenständiger Computer fungiert. Der Mikrokontroller umfasst beispielsweise einen Prozessor (CPU), einen Speicher (RAM und ROM) und verschiedene Ein- und Ausgabeschnittstellen in einem einzigen Chip.

In einer Ausführungsform wird vorgeschlagen, dass die Differenziator-Schaltung einen Kondensator zur Störungsdämpfung aufweist, der in Parallelschaltung angeordnet ist.

Eine Differenziator-Schaltung mit einem Kondensator zur Störungsdämpfung in Parallelschaltung ist vorzugsweise so konzipiert, dass sie die Ableitung des Eingangssignals bildet und dadurch besonders empfindlich auf schnelle Signaländerungen reagiert. Ein Kondensator wird vorzugsweise in die Schaltung integriert, um hochfrequente Störungen, die beispielsweise durch Rauschen oder externe Einflüsse entstehen können, zu dämpfen. Dieser Kondensator ist vorzugsweise parallel zu dem Widerstand der Differenziator-Schaltung angeordnet. Durch diese Parallelschaltung werden vorzugsweise hohe Frequenzen begrenzt und das Ausgangssignal stabilisiert, was die Schaltung widerstandsfähiger gegen Störungen macht.

In einer Ausführungsform wird vorgeschlagen, dass der Schutzschalter einen Bypass-Pfad, umfassend eine Diode und einen Widerstand, aufweist, wobei der Bypass-Pfad dazu ausgebildet ist, die Zwischenkreiskapazität aufzuladen, wenn der Schutzschalter geöffnet ist.

Der Bypass-Pfad dient dazu, den Kondensator des Zwischenkreises kontrolliert aufzuladen. Die Diode sorgt dabei dafür, dass der Strom nur in eine bestimmte Richtung fließt, wodurch der Ladeprozess kontrolliert abläuft. Der Widerstand begrenzt den Stromfluss, sodass der Zwischenkreiskondensator nur langsam geladen wird, anstatt sich sofort vollständig aufzuladen. Dies erzeugt eine Verzögerung oder einen sanften Anstieg der Spannung am Zwischenkreiskondensator. Wenn der Zwischenkreiskondensator schließlich die erforderliche Spannung erreicht, kann der Schutzschalter geschlossen werden.

In einer Ausführungsform wird vorgeschlagen, dass der Flipflopspeicher zum zumindest temporären Speichern des Komparator-Signals ausgebildet ist.

Ein Flipflop-Speicher, der zum zumindest temporären Speichern des Komparator-Signals ausgebildet ist, dient dazu, den Ausgangszustand des Komparators für eine gewisse Zeit festzuhalten. Der Komparator gibt vorzugsweise ein Signal aus, das entweder einen hohen (1) oder niedrigen (0) Pegel hat, abhängig von dem Spannungsvergleich. Dieses Signal kann flüchtig sein, also schnell wechseln, abhängig von den Eingangsbedingungen. Der Flipflop-Speicher speichert nun dieses Signal, sodass es auch dann verfügbar bleibt, wenn das Komparator-Signal selbst nicht mehr anliegt. Diese Speicherung ermöglicht es, das Komparator-Ergebnis festzuhalten und es nachfolgend in der Schaltung weiterzuverarbeiten oder zu nutzen, auch wenn sich die Eingangsspannungen des Komparators ändern.

In einem weiteren Aspekt wird ein Verfahren zum Schalten eines Schutzschalters einer Antriebseinheit für eine mobile Werkzeugmaschine vorgeschlagen, wobei die Antriebseinheit eine Akkueinheit zum Bereitstellen einer ausgangsseitigen Gleichspannung, einen Elektromotor, eine Motorinverter-Schaltung, die zwischen der Akkueinheit und dem Elektromotor geschaltet ist, und durch die die von der Akkueinheit bereitgestellte Gleichspannung taktbar ist, um den Elektromotor anzutreiben, eine Zwischenkreiskapazität, die zwischen der Akkueinheit und der Motorinverter-Schaltung geschaltet und durch die eine Zwischenkreisspannung definiert ist; und eine Schutzschalteinrichtung mit einem Schutzschalter aufweist, wobei das Verfahren die Schritte aufweist:
a) Erfassen eines Spannungsgradienten der Zwischenkreisspannung; und
b) Schalten des Schutzschalters zum Trennen der Akkueinheit von der Motorinverter-Schaltung unter Verwendung des Spannungsgradienten.

Weiterhin wird ein Computerprogrammprodukt vorgeschlagen, welches Befehle umfasst, die bei der Ausführung des Programms durch einen Computer diesen veranlassen, das vorstehend beschriebene Verfahren auszuführen.

Ein Computerprogrammprodukt, wie z.B. ein Computerprogramm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen.

Die für das vorgeschlagene Verfahren beschriebenen Ausführungsformen und Merkmale gelten für die vorgeschlagene Werkzeugmaschine entsprechend.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.

### KURZE BESCHREIBUNG DER FIGUREN

Die nachfolgende Beschreibung erläutert die Erfindung anhand von exemplarischen Ausführungsformen und Figuren. In den Figuren zeigt:
- Fig. 1: eine schematische Ansicht einer akkubetriebenen mobilen Werkzeugmaschine;
- Fig. 2: eine schematische Ansicht einer Antriebseinheit;
- Fig. 3: eine weitere schematische Ansicht einer Antriebseinheit;
- Fig. 4: eine weitere schematische Ansicht einer Antriebseinheit
- Fig. 5: ein Strom- bzw. Spannungs-Zeit-Diagramm eines Kurzschlussfalls;
- Fig. 6: eine schematische Ansicht einer Differenziator-Schaltung; und
- Fig. 7: ein schematisches Flussdiagramm eines vorliegenden Verfahrens.

Gleiche oder funktionsgleiche Elemente werden durch gleiche Bezugszeichen in den Figuren indiziert, soweit nichts anderes angegeben ist.

### AUSFÜHRUNGSFORMEN DER ERFINDUNG

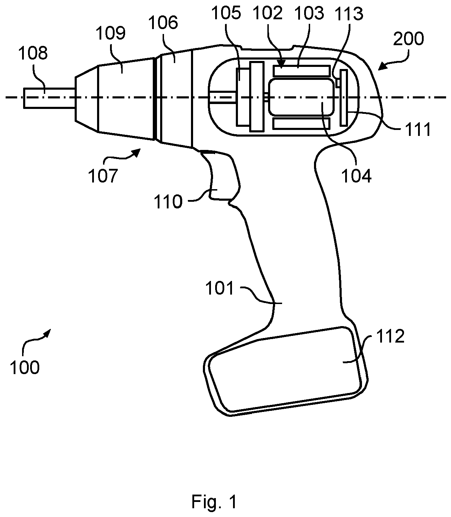

Die Fig. 1 zeigt eine mobile Werkzeugmaschine 100. Die Werkzeugmaschine 100 ist beispielhaft eine Handwerkzeugmaschine, genauer gesagt eine Bohrmaschine. Weitere bevorzugte Ausführungsformen umfassen eine Meißelmaschine, eine Schleifmaschine oder eine Sägemaschine. Die Werkzeugmaschine 100 hat ein Gehäuse 101 zum Schützen und Lagern weiterer Bauteile. Die Werkzeugmaschine 100 ist als tragbares Gerät ausgebildet. Sie weist beispielsweise ein Gewicht zwischen 0,5 und 15 kg und allgemein von weniger als 25 kg oder 50 kg auf.

Die Werkzugmaschine 100 hat einen Elektromotor 102, der einen Stator 103 und einen Rotor 104 hat. Der Rotor 104 ist beispielsweise über ein Getriebe 105 mit einer Spindel 106 einer Werkezugaufnahme 107 rotationsgekoppelt. Das Getriebe 105 ist beispielsweise ein Untersetzungsgetriebe. Es kann sein, dass das Getriebe 105 zwischen mehreren Übersetzungen schaltbar ist. Es kann sein, dass die Werkzeugmaschine 100 ein Schlagwerk enthält, das als Teil des Getriebes 105 oder der Werkzeugaufnahme 107 ausgeführt und/oder zwischen das Getriebe 105 und die Werkzeugaufnahme 107 geschaltet ist.

Die Werkzeugaufnahme 107 ist vorzugsweise zur Aufnahme eines wechselbaren Werkzeugs 108 konfiguriert. Beispielsweise kann durch ein Verdrehen eines Griffs 109 der Werkzeugaufnahme 107 gegenüber der Spindel 106 ein (nicht dargestelltes) Futter der Werkzeugaufnahme 107 geöffnet und/oder geschlossen werden. Beispielsweise handelt es sich um ein Schnellspannbohrfutter, ein SDS-Bohrfutter und/oder ein TE-C-Borfutter. Mittels der Werkzeugaufnahme 107 ist das Werkzeug 108 beispielsweise rotierend und/oder schlagend und/oder hämmernd antreibbar.

Der Elektromotor 102 ist beispielsweise ein bürstenloser Gleichstrommotor. Der Elektromotor 102 ist zum Erzeugen eines Drehmoments zwischen dem Stator 103 und dem Rotor 104 betreibbar. Eine Steuervorrichtung 111 ist dazu konfiguriert, auf eine Betätigung eines Betätigungselements 110 hin einen elektrischen Stromfluss von einer Akkueinheit 112 zu dem Stator 103 zu schalten. Die Akkueinheit 112 ist vorzugsweise ein Akkumulator oder eine Schaltung mehrerer Akkumulatoren.

Beispielsweise ist die Steuervorrichtung 111 dazu eingerichtet, eine Rotationslage (Rotationswinkel und/oder Winkelgeschwindigkeit) des Rotors 104 relativ zu dem Gehäuse 101 mittels einer Hallsensorschaltung 113 oder einer anderen Winkelsensoreinrichtung zu erfassen. Zum Beispiel können auch AMR-Sensoren und/oder Resolver eingesetzt werden. Ferner ist auch eine Winkelschätzung durch sensorlose Algorithmen denkbar. Ferner ist im Falle von bürstenlosen Gleichstrommotoren keine Winkelmessung notwendig. Beispielsweise ist die Steuervorrichtung 111 weiterhin dazu eingerichtet, (in Fig. 1 nicht dargestellte) Wicklungen des Stators 103 mit elektrischem Strom zu beaufschlagen. Die Steuervorrichtung 111 hat dazu beispielsweise eine Auswertelogik, und sie kann beispielsweise zum Ausführen eines Computerprogramms eingerichtet sein, dessen Befehle die Steuervorrichtung 111 dazu bringen, ein Verfahren zum Betreiben der mobilen Werkzeugmaschine 100 auszuführen.

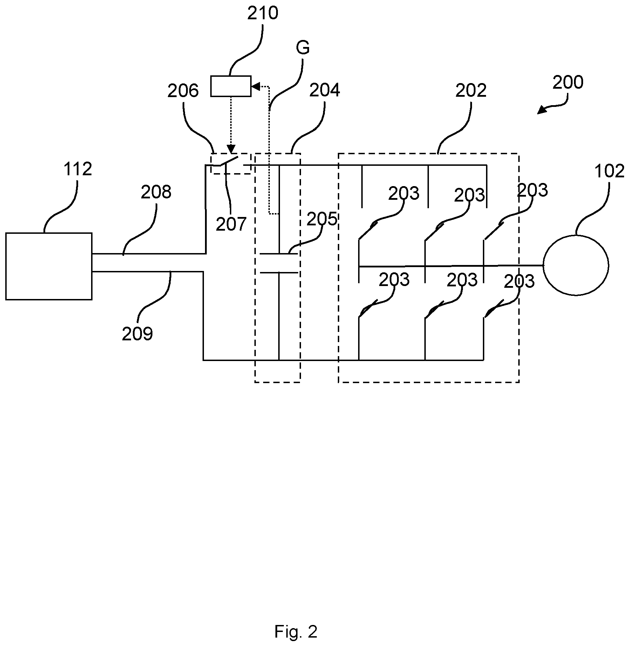

Fig. 2 zeigt eine Antriebseinheit 200 der Werkzugmaschine 100 in einer Ausführungsform. Die Antriebseinheit 200 umfasst die Akkueinheit 112 zum Bereitstellen einer ausgangsseitigen Gleichspannung, den Elektromotor 102, eine Motorinverter-Schaltung 202, die zwischen der Akkueinheit 112 und dem Elektromotor 102 geschaltet ist, und durch die die von der Ackueinheit 112 bereitgestellte Gleichspannung taktbar ist, um den Elektromotor 108 anzutreiben. Die Motorinverter-Schaltung 202 umfasst vorliegend sechs Transistoren 203, insbesondere MOSFETs, zum Takten der bereitgestellten Gleichspannung.

Die Antriebseinheit 200 umfasst ferner einen Zwischenkreiskapazität 204, die zwischen der Akkueinheit 112 und der Motorinverter-Schaltung 202 geschaltet und durch die eine Zwischenkreisspannung definiert ist. Die Zwischenkreiskapazität 204 umfasst einen Zwischenkreiskondensator 205. Der Zwischenkreiskondensator 205 kann ein keramischer Kondensator sein.

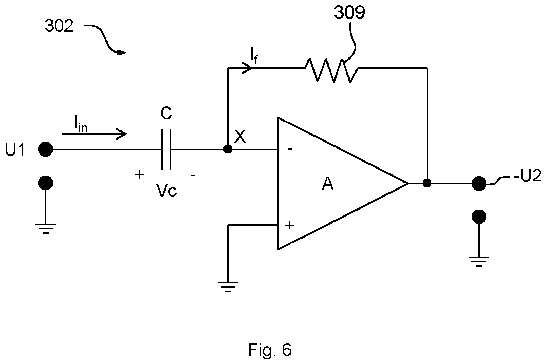

Auch umfasst die Antriebseinheit 200 eine Schutzschalteinrichtung 206 mit einem Schutzschalter 207. Der Schutzschalter 207 umfasst einen Transistor, insbesondere einen MOSFET. Die Schutzschalteinrichtung 206 ist vorliegend dazu ausgebildet, einen Spannungsgradienten G (siehe Fig. 6) der Zwischenkreisspannung, die an dem Zwischenkreiskondensator 205 anliegt, zu erfassen, und unter Verwendung des Spannungsgradienten G den Schutzschalter 207 zum Trennen der Akkueinheit 112 von der Motorinverter-Schaltung 202 zu schalten. Der Schutzschalter 207 ist dabei in einer Zuleitung 208 zu einer positiven Elektrode der Akkueinheit 112 bzw. zwischen der Akkueinheit 112 und der Zwischenkreiskapazität 204 angeordnet. Alternativ kann der Schutzschalter 207 in einer Ableitung 209 zu einer negativen Elektrode der Akkueinheit 112 bzw. zwischen der Akkueinheit 112 und der Zwischenkreiskapazität 204 angeordnet sein.

Die Schutzschalteinrichtung 206 mit der Steuervorrichtung 111 verbunden sein, durch die das Schalten des Schutzschalters 207 unter Verwendung des Spannungsgradienten G ausführen kann. Auch kann die Steuervorrichtung 111 dazu ausgebildet sein, den Spannungsgradienten G zu erfassen. Alternativ kann die Schutzschalteinrichtung 206 auch eine weitere Steuereinrichtung aufweisen, die das Erfassen des Spannungsgradienten G und/oder das Schalten des Schutzschalters 207 unter Verwendung des Spannungsgradienten G durchführen kann.

Die Schutzschalteinrichtung 206 kann auch einen Mikrokontroller 210 aufweisen, der dazu ausgebildet ist, unter Verwendung des Komparator-Signals den Schutzschalter 207 zu schalten, um die Akkueinheit 112 von der Motorinverter-Schaltung 202, insbesondere in einem Kurzschlussfall, zu trennen.

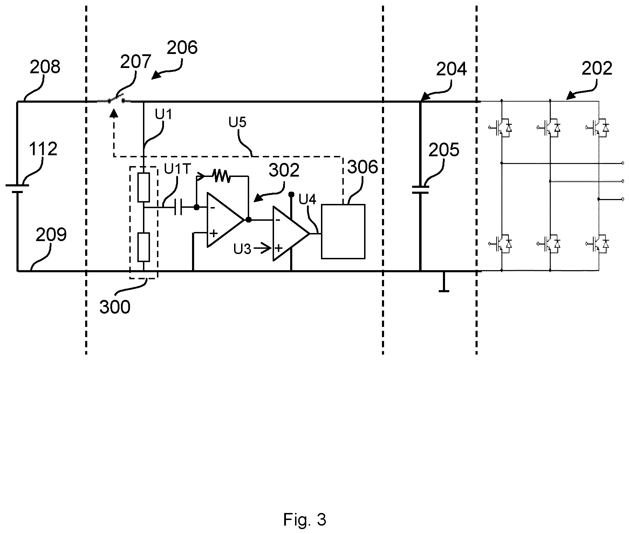

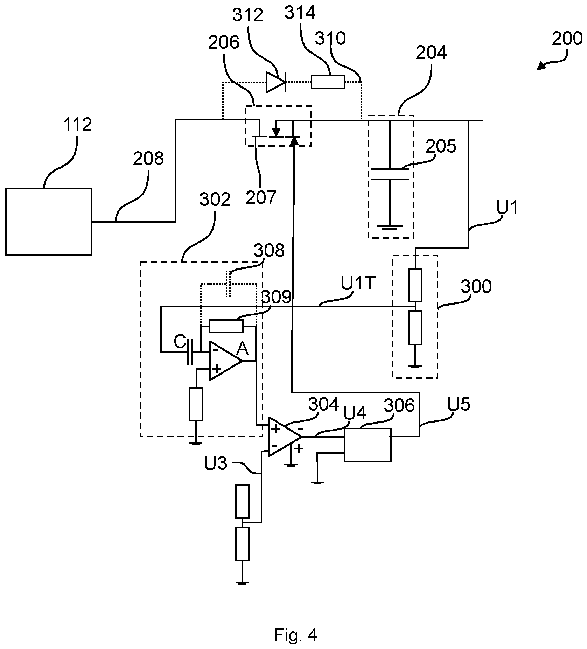

Fig. 3 und 4 zeigen weitere Ausführungsformen der Antriebseinheit 200. Die Schutzschalteinrichtung 206 weist einen Spannungsteiler 300 zum Teilen der Zwischenkreisspannung U1 und eine Differenziator-Schaltung 302 zum Erfassen des Spannungsgradienten G unter Verwendung der geteilten Zwischenkreisspannung U1T auf. Die Differenziator-Schaltung 302 ist schematisch auch nochmals in Fig. 6 in einer weiteren Ausführung gezeigt.

Die Differenziator-Schaltung 302 ist dazu ausgebildet, ein Ausgangsspannungssignal U2 zu erzeugen, das dem Spannungsgradienten G der Zwischenkreisspannung U1 entspricht.

Ferner weist die Schutzschalteinrichtung 206 einen Komparator 304 auf, durch den zum einen ein Schwellenwert U3 zum Schalten des Schutzschalters 207 einstellbar ist, und der zum anderen dazu ausgebildet ist, das Ausgangsspannungssignal U2 mit dem Schwellenwert U3 zu vergleichen, und auf Basis des Vergleichs ein Komparator-Signal U4 auszugeben. Der Schwellenwert U3 wird dabei vorzugsweise mittels eines Spannungsteilers erzeugt.

In anderen Ausführungen kann die Antriebseinheit auch anstelle einer Schutzschaltereinrichtung 206 eine Messeinrichtung aufweisen, die dazu ausgebildet ist, einen Spannungsgradienten G der Zwischenkreisspannung U1 zu erfassen, und unter Verwendung des Spannungsgradienten G die Motorinverter-Schaltung 202 abzuschalten. Die Messeinrichtung kann dabei den Spannungsteiler 300 zum Teilen der Zwischenkreisspannung U1 und die Differenziator-Schaltung 302 zum Erfassen des Spannungsgradienten G unter Verwendung der geteilten Zwischenkreisspannung U1T aufweisen.

Gemäß der in Fig. 4 gezeigten Ausführung weist die Schutzschalteinrichtung 206 einen Flipflopspeicher 306 auf, der dazu ausgebildet ist, unter Verwendung des Komparator-Signals U4 den Schutzschalter 207 mittels eines Schaltsignals U5 zu schalten, um die Akkueinheit 112 von der Motorinverter-Schaltung 202, insbesondere in einem Kurzschlussfall, zu trennen. Der Flipflopspeicher 306 ist zum zumindest temporären Speichern des Komparator-Signals U4 ausgebildet. Dies gilt auch analog für die Messeinrichtung.

Rein beispielhaft weist die Differenziator-Schaltung 302 gemäß Fig. 4 noch einen Kondensator 308 zur Störungsdämpfung auf, der in Parallelschaltung zu einem Widerstand 309 der Differenziator-Schaltung 302 angeordnet ist.

Rein beispielhaft weist der Schutzschalter 207 gemäß Fig. 4 noch einen Bypass-Pfad 310 auf. Der Bypass-Pfad 310 umfasst eine Diode 312 und einen Widerstand 314. Der Bypass-Pfad 310 ist dazu ausgebildet, die Zwischenkreiskapazität 204 aufzuladen, wenn der Schutzschalter 207 (zunächst noch), d.h. beim Einschalten der mobilen Werkzeugmaschine 100, geöffnet ist.

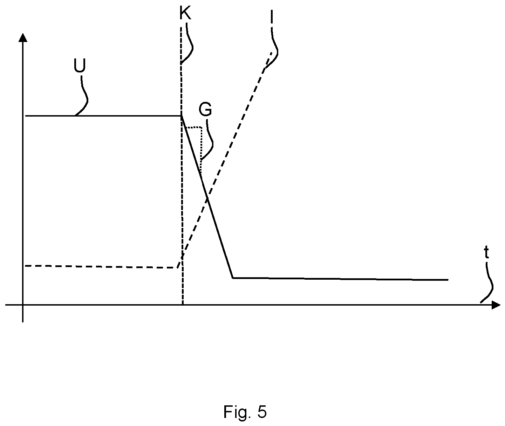

Fig. 5 zeigt ein Strom- bzw. Spannungs-Zeit-Diagramm eines Kurzschlussfalls. Dabei sind der Strom I und die Spannung U innerhalb der Antriebseinheit 200 im zeitlichen Verlauf t aufgetragen. Im Falle eines Kurzschlusses K, beispielsweise im Zwischenkreis der Antriebseinheit 200, bricht die Spannung U innerhalb kürzester Zeit t ein, sodass ein hoher Spannungsgradient G entsteht. Ein Kurzschluss-Ereignis kann vorliegend anhand des Spannungsgradienten G (und nicht wie üblich anhand eines Messstroms über einen Messwiderstand) erfasst werden.

Fig. 6 zeigt ein Ausführungsbeispiel der Differenziator-Schaltung 302. Dabei ist eine Schaltung eines Operationsverstärker-Differenziators gezeigt. Die Zwischenkreisspannung U1 dient als Eingangssignal und wird an einen Kondensator C angelegt, der mit seinem einen Anschluss mit dem Bezugspotential (Masse) und mit seinem anderen Anschluss mit dem Knotenpunkt X verbunden ist. Der Knotenpunkt X ist wiederum mit dem invertierenden Eingang eines Operationsverstärkers A verbunden. Der nicht invertierende Eingang des Operationsverstärkers A ist auf Massepotential gelegt.

Der Widerstand 309 ist zwischen dem Knotenpunkt X und dem Ausgang des Operationsverstärkers A geschaltet. Der Strom durch den Widerstand wird mit If bezeichnet, während der Strom, der in den Knoten X fließt, als lin bezeichnet ist. Das Ausgangsspannungssignal -U2 der Schaltung ist ebenfalls mit dem Massepotential verbunden.

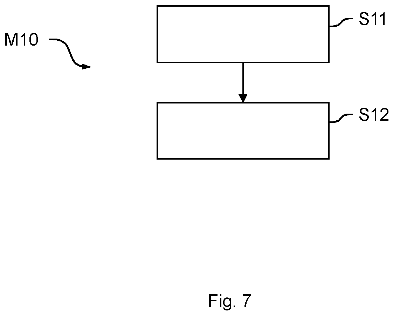

Fig. 7 zeigt ein schematisches Flussdiagramm eines vorliegenden Verfahrens M10 zum Schalten eines Schutzschalters 200. Das Verfahren M10 weist in einem Schritt S11 ein Erfassen eines Spannungsgradienten G der Zwischenkreisspannung auf. Ferner weist das Verfahren M10 in einem Schritt S12 ein Schalten des Schutzschalters 207 zum Trennen der Akkueinheit 112 von der Motorinverter-Schaltung 202 unter Verwendung des Spannungsgradienten G auf. Die Schritte S11 und S12 können jeweils mehrere Unterschritte aufweisen.

Dabei kann ein Computerprogrammprodukt vorgesehen sein, welches Befehle umfasst, die bei der Ausführung des Programms durch einen Computer diesen veranlassen, das Verfahren M 10 auszuführen, um so den Schutzschalter 207 zu schalten. Das Verfahren M10 kann beispielsweise auf der Steuereinrichtung 111 oder auf dem Mikrokontroller 210 ausführbar sein.

Obwohl die vorliegende Erfindung anhand von Ausführungsbeispielen beschrieben wurde, ist sie vielfältig modifizierbar. Die Ausführungen gelten auch für die Messeinrichtung.

### BEZUGSZEICHENLISTE

- 100: mobile Werkzeugmaschine
- 101: Gehäuse
- 102: Elektromotor
- 103: Stator
- 104: Rotor
- 105: Getriebe
- 106: Spindel
- 107: Werkzeugaufnahme
- 108: Werkzeug
- 109: Griff
- 110: Betätigungselement
- 111: Steuervorrichtung
- 112: Akkueinheit
- 113: Hallsensorschaltung
- 200: Antriebseinheit
- 202: Motorinverter-Schaltung
- 203: Transistor
- 204: Zwischenkreiskapazität
- 205: Zwischenkreiskondensator
- 206: Schutzschalteinrichtung
- 207: Schutzschalter
- 208: Zuleitung der positiven Elektrode
- 209: Ableitung der negativen Elektrode
- 210: Mikrokontroller
- 300: Spannungsteiler
- 302: Differenziator-Schaltung
- 304: Komparator
- 306: Flipflopspeicher
- 308: Kondensator
- 309: Widerstand der Differenziator-Schaltung
- 310: Bypass-Pfad
- 312: Diode des Bypass-Pfades
- 314: Widerstand des Bypass-Pfades
- A: Operationsverstärker
- I: Strom
- lin: Strom
- If: Strom
- C: Kondensator
- U: Spannung
- U1: Zwischenkreisspannung
- U1T: geteilte Zwischenkreisspannung
- U2: Ausgangsspannungssignal
- U3: Schwellenwert
- U4: Komparator-Signal
- U5: Schaltsignal
- t: Zeit
- G: Spannungsgradient
- K: Kurzschluss
- X: Knotenpunkt

- M10: Verfahren zum Schalten eines Schutzschalters
- S11: Erfassen eines Spannungsgradienten der Zwischenkreisspannung
- S12: Schalten des Schutzschalters

## Patentansprüche

1. Antriebseinheit (200) für eine mobile Werkzeugmaschine (100), aufweisend:
eine Akkueinheit (112) zum Bereitstellen einer ausgangsseitigen Gleichspannung;
einen Elektromotor (102);
eine Motorinverter-Schaltung (202), die zwischen der Akkueinheit (112) und dem Elektromotor (102) geschaltet ist, und durch die die von der Akkueinheit (112) bereitgestellte Gleichspannung taktbar ist, um den Elektromotor (108) anzutreiben;
eine Zwischenkreiskapazität (204), die zwischen der Akkueinheit (112) und der Motorinverter-Schaltung (202) geschaltet und durch die eine Zwischenkreisspannung (U1) definiert ist; und
eine Schutzschalteinrichtung (206) mit einem Schutzschalter (207),
**dadurch gekennzeichnet, dass**
die Schutzschalteinrichtung (206) dazu ausgebildet ist, einen Spannungsgradienten (G) der Zwischenkreisspannung (U1) zu erfassen, und unter Verwendung des Spannungsgradienten (G) den Schutzschalter (207) zum Trennen der Akkueinheit (112) von der Motorinverter-Schaltung (202) zu schalten.

2. Antriebseinheit (200) nach Anspruch 1, wobei der Schutzschalter (207) einen Transistor, insbesondere einen MOSFET, aufweist.

3. Antriebseinheit (200) nach Anspruch 1 oder 2, wobei die Schutzschalteinrichtung (206) einen Spannungsteiler (300) zum Teilen der Zwischenkreisspannung (U1) und eine Differenziator-Schaltung (302) zum Erfassen des Spannungsgradienten (G) unter Verwendung der geteilten Zwischenkreisspannung (U1T) aufweist.

4. Antriebseinheit (200) nach Anspruch 3, wobei die Differenziator-Schaltung (302) dazu ausgebildet ist, ein Ausgangsspannungssignal (U2) zu erzeugen, das dem Spannungsgradienten (G) der Zwischenkreisspannung (U1) entspricht.

5. Antriebseinheit (200) nach Anspruch 4, wobei die Schutzschalteinrichtung (206) einen Komparator (304) aufweist, durch den ein Schwellenwert (U3) zum Schalten des Schutzschalters (207) einstellbar ist, und der dazu ausgebildet ist, das Ausgangsspannungssignal (U2) mit dem Schwellenwert (U3) zu vergleichen, und auf Basis des Vergleichs ein Komparator-Signal (U4) auszugeben.

6. Antriebseinheit (200) nach Anspruch 5, wobei die Schutzschalteinrichtung (206) einen Flipflopspeicher (306) oder einen Mikrokontroller (210) aufweist, wobei der Flipflopspeicher (306) oder der Mikrokontroller (210) dazu ausgebildet ist, unter Verwendung des Komparator-Signals (U4) den Schutzschalter (207) zu schalten, um die Akkueinheit (112) von der Motorinverter-Schaltung (202), insbesondere in einem Kurzschlussfall, zu trennen.

7. Antriebseinheit (200) nach einem der Ansprüche 3 bis 6, wobei die Differenziator-Schaltung (302) einen Kondensator (308) zur Störungsdämpfung aufweist, der in Parallelschaltung angeordnet ist.

8. Antriebseinheit (200) nach einem der vorigen Ansprüche, wobei der Schutzschalter (207) einen Bypass-Pfad (310), umfassend eine Diode (312) und einen Widerstand (314), aufweist, wobei der Bypass-Pfad (310) dazu ausgebildet ist, die Zwischenkreiskapazität (204) aufzuladen, wenn der Schutzschalter (207) geöffnet ist.

9. Antriebseinheit (200) nach Anspruch 6, wobei der Flipflopspeicher (306) zum zumindest temporären Speichern des Komparator-Signals (U4) ausgebildet ist.

10. Mobile Werkzeugmaschine (100), umfassend eine Antriebseinheit (200) nach einem der Ansprüche 1 bis 9.

11. Verfahren (M10) zum Schalten eines Schutzschalters (207) einer Antriebseinheit (200) für eine mobile Werkzeugmaschine (100), wobei die Antriebseinheit (200) eine Akkueinheit (112) zum Bereitstellen einer ausgangsseitigen Gleichspannung, einen Elektromotor (102), eine Motorinverter-Schaltung (202), die zwischen der Akkueinheit (112) und dem Elektromotor (102) geschaltet ist, und durch die die von der Akkueinheit (112) bereitgestellte Gleichspannung taktbar ist, um den Elektromotor (108) anzutreiben, eine Zwischenkreiskapazität (204), die zwischen der Akkueinheit (112) und der Motorinverter-Schaltung (202) geschaltet und durch die eine Zwischenkreisspannung (U1) definiert ist; und eine Schutzschalteinrichtung (206) mit einem Schutzschalter (207) aufweist, wobei das Verfahren (M10) die Schritte aufweist:
Erfassen (S11) eines Spannungsgradienten (G) der Zwischenkreisspannung (U1); und
Schalten (S12) des Schutzschalters (207) zum Trennen der Akkueinheit (112) von der Motorinverter-Schaltung (202) unter Verwendung des Spannungsgradienten (G).

12. Computerprogrammprodukt, welches Befehle umfasst, die bei der Ausführung des Programms durch einen Computer diesen veranlassen, das Verfahren (M10) nach Anspruch 11 auszuführen.

13. Antriebseinheit (200) für eine mobile Werkzeugmaschine (100), aufweisend:
eine Akkueinheit (112) zum Bereitstellen einer ausgangsseitigen Gleichspannung;
einen Elektromotor (102);
eine Motorinverter-Schaltung (202), die zwischen der Akkueinheit (112) und dem Elektromotor (102) geschaltet ist, und durch die die von der Akkueinheit (112) bereitgestellte Gleichspannung taktbar ist, um den Elektromotor (108) anzutreiben;
eine Zwischenkreiskapazität (204), die zwischen der Akkueinheit (112) und der Motorinverter-Schaltung (202) geschaltet und durch die eine Zwischenkreisspannung (U1) definiert ist; und
eine Messeinrichtung, die dazu ausgebildet ist, einen Spannungsgradienten (G) der Zwischenkreisspannung (U1) zu erfassen, und unter Verwendung des Spannungsgradienten (G) die Motorinverter-Schaltung (202) abzuschalten.
